# FASCICULE DE BREVET EUROPEEN

(11) **EP 4 603 847 B1**
(45) Date de publication et mention de la délivrance du brevet: **24.06.2026**
(21) Numéro de dépôt: 24217843.2
(22) Date de dépôt: 05.12.2024
(51) Int. Cl.: G01R 1/20, G01R 1/44, G01R 31/327

(54) **APPAREILLAGE ELECTRIQUE DE COUPURE AVEC MESURE DU COURANT**
ELEKTRISCHES SCHALTGERÄT MIT STROMMESSUNG
ELECTRICAL SWITCHGEAR WITH CURRENT MEASUREMENT

(30) Priorité: 16.02.2024 FR 2401567
(43) Date de publication de la demande: 20.08.2025
(73) Titulaire: HAGER-ELECTRO SAS, 67210 Obernai (FR)
(72) Inventeur: ZEISSLOFF, Thibaut, 67210 BERNARDSWILLER (FR)
(74) Mandataire: Ipsilon

(56) Documents cités:
- EP-A1- 3 644 077

## Description

La présente invention concerne le domaine des appareillages électriques de coupure avec mesure du courant.

Dans le domaine des appareillages électriques de coupure et de protection tels que par exemple les disjoncteurs nécessitant de l'électronique de déclenchement, il est commun de retrouver des capteurs de courant de type transformateur de courant ou tore de Rogowski disposés autour de la ligne de courant de phase pour mesurer le courant circulant dans la ligne de courant de phase.

Ce type de capteurs présente notamment deux avantages, ils ont une faible impédance d'un point de vue de la ligne de courant de phase et présentent une isolation galvanique. Toutefois, ils présentent aussi les inconvénients d'être encombrants, difficiles à implémenter dans l'appareillage électrique de protection, et complexes à produire avec une bonne répétabilité ce qui implique des coûts de production élevés. En outre, ces capteurs sont bien adaptés pour des appareillages électriques de coupure et de protection fonctionnant en courant alternatif mais pas pour ceux fonctionnant en courant continu.

Il est connu de remplacer ce type de capteurs par un shunt pour permettre la mesure de courant. Toutefois, l'utilisation de shunt dans un disjoncteur n'est pas sans poser de difficultés. En effet, un shunt présente le désavantage d'insérer une partie résistive supplémentaire sur la ligne de courant de phase, ce qui accroît nécessairement la dissipation. De plus, un autre inconvénient de l'usage d'un shunt est qu'il complexifie l'agencement de la ligne de courant de phase. Tous ces inconvénients n'incitent pas l'homme du métier à remédier à cette solution pour mesurer le courant sur la ligne de courant de phase. EP3 644 077 A1 divulgue un système de diagnostic d'anomalie de relais.

La présente invention a pour but de pallier au moins l'un de ces inconvénients et de proposer notamment une solution de mesure du courant qui soit compacte, et aisée à implémenter dans ledit appareillage électrique de coupure.

A cet effet, l'invention concerne un appareillage électrique de coupure comportant au moins :
- une ligne de courant de phase comprenant au moins un conducteur métallique de phase,
- une unité de coupure comprenant au moins un élément de commutation sur la ligne de courant de phase,
- une unité de mesure comprenant au moins un capteur de courant et un circuit de mesure du courant,
appareillage électrique de coupure caractérisé en ce que :
le capteur de courant intègre un segment dudit conducteur métallique de phase situé entre un premier point de connexion et un deuxième point de connexion distants l'un de l'autre d'une distance prédéfinie et en ce que l'unité de mesure comprend un premier conducteur raccordé par une première extrémité au premier point de connexion et par une deuxième extrémité au circuit de mesure du courant et un deuxième conducteur raccordé par une première extrémité au deuxième point de connexion et par une deuxième extrémité au circuit de mesure du courant et
l'unité de mesure comprend en outre un capteur de température et un circuit de mesure de la température et au moins un câble de thermocouple comprenant un troisième conducteur et un quatrième conducteur reliés l'un l'autre au niveau d'une soudure dite froide et une soudure dite chaude, le troisième conducteur comprenant une première extrémité et une deuxième extrémité, et le quatrième conducteur comprenant une première extrémité et une deuxième extrémité, lesquels sont raccordés respectivement par leur première extrémité à un troisième point de connexion confondu avec le ou à proximité du deuxième point de connexion et étant au voisinage de la soudure chaude et à leur deuxième extrémité, étant voisine de la soudure dite froide, au circuit de mesure de la température,
ladite unité de mesure est configurée au moins pour mesurer la valeur de la différence de tension entre le premier conducteur et le deuxième conducteur, la valeur de la différence de tension du câble de thermocouple et la valeur de la température absolue à proximité de la soudure dite froide à l'aide du capteur de température, de sorte à déterminer la valeur du courant circulant dans le conducteur métallique de phase.

L'invention sera mieux comprise, grâce à la description ci-après, qui se rapporte à plusieurs modes de réalisation préférés, donnés à titre d'exemples non limitatifs, et expliqués avec référence aux dessins schématiques annexés, dans lesquels :
[Fig. 1] la figure 1 représente une vue de côté partielle d'un appareillage électrique de coupure selon une première variante de réalisation selon l'invention,
[Fig. 2] la figure 2 représente une vue partielle de côté et en perspective d'un appareillage électrique de coupure selon une deuxième variante de réalisation selon l'invention, et
[Fig. 3] la figure 3 représente une vue schématique et partielle d'une unité de mesure selon une possibilité de l'invention.

Un appareillage électrique de coupure comporte au moins :
- une ligne de courant de phase L comprenant au moins un conducteur métallique de phase 1,
- une unité de coupure 2 comprenant au moins un élément de commutation 3a,3b sur la ligne de courant de phase L,
- une unité de mesure 6 comprenant au moins un capteur de courant 7 et un circuit de mesure du courant 8.

Conformément à l'invention l'appareillage électrique de coupure est caractérisé en ce que :
- le capteur de courant 7 intègre un segment 9 dudit conducteur métallique de phase 1 situé entre un premier point de connexion P1 et un deuxième point de connexion P2 distants l'un de l'autre d'une distance D prédéfinie et en ce que l'unité de mesure 6 comprend un premier conducteur 10 raccordé par une première extrémité 11 au premier point de connexion P1 et par une deuxième extrémité 12 au circuit de mesure du courant 8 et un deuxième conducteur 13 raccordé par une première extrémité 14 au deuxième point de connexion P2 et par une deuxième extrémité 15 au circuit de mesure du courant 8 et
- l'unité de mesure 6 comprend en outre un capteur de température 16 et un circuit de mesure de la température 17 et au moins un câble de thermocouple 18 comprenant un troisième conducteur 19 et un quatrième conducteur 20 reliés l'un l'autre au niveau d'une soudure dite froide et une soudure dite chaude, le troisième conducteur 19 comprenant une première extrémité 21 et une deuxième extrémité 22, et le quatrième conducteur 20 comprenant une première extrémité 23 et une deuxième extrémité 24, lesquels sont raccordés respectivement par leur première extrémité 21, 23 à un troisième point de connexion P3 confondu avec le ou à proximité du deuxième point de connexion P2 et étant au voisinage de la soudure chaude et à leur deuxième extrémité 22, 24, étant voisine de la soudure dite froide, au circuit de mesure de la température 17,
- ladite unité de mesure 6 est configurée au moins pour mesurer la valeur de la différence de tension Vshunt entre le premier conducteur 10 et le deuxième conducteur 13, la valeur de la différence de tension du câble de thermocouple 18 VthC et la valeur de la température absolue VΘRef à proximité de la soudure dite froide à l'aide du capteur de température 16, de sorte à déterminer la valeur du courant circulant dans le conducteur métallique de phase 1.

Avantageusement, la configuration selon l'invention permet d'utiliser une portion du conducteur métallique de phase 1 de la ligne de courant de phase L existant dans l'appareillage électrique de coupure comme un shunt, c'est-à-dire en utilisant la faible résistance d'une pièce métallique pour mesurer la chute de tension due au courant primaire. On évite ainsi l'ajout d'une pièce résistive. Plus précisément, il suffit d'effectuer une mesure de la tension entre deux premier et deuxième points de connexion P1, P2 sur le conducteur métallique de phase 1, et qui soient suffisamment espacés de la distance D sur le conducteur métallique de phase 1 pour obtenir une chute de tension Vshunt qui soit mesurable. Cette approche est toutefois compliquée par différents effets, le plus important étant l'échauffement du conducteur métallique de phase 1. C'est pourquoi, la configuration selon l'invention comprend en plus de la mesure de la chute de tension Vshunt, une mesure de la chute de tension du câble de thermocouple 18 VthC au troisième point de connexion P3 et une mesure de température absolue VΘRef à proximité de la soudure dite froide. Grâce à l'invention, une mesure très précise de température du conducteur métallique de phase 1 peut être obtenue ce qui permet de réaliser une compensation adaptée de la chute de tension Vshunt afin d'en déduire une mesure du courant circulant dans le conducteur métallique de phase 1 avec une exactitude optimale. Cette solution présente en outre l'avantage d'être peu couteuse, d'être compacte, et d'offrir une meilleure linéarité et donc une meilleure performance, notamment comparativement aux moyens de mesure de courant existants pour des appareillages électriques de coupure et de protection fonctionnant en courant alternatif tels que des tores de Rogowski. Par ailleurs, cette solution est adaptée pour la mesure du courant pour des appareillages électriques de coupure fonctionnant en courant alternatif mais aussi en courant continu.

De préférence, la ligne de courant de phase L comprend une borne de connexion amont 25 et une borne de connexion aval 26, ladite unité de coupure 2 étant située entre la borne de connexion amont 25 et la borne de connexion aval 26.

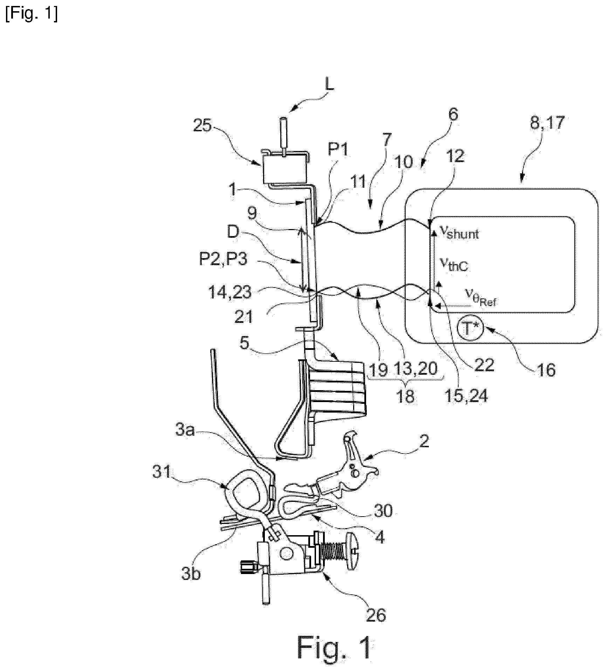

Selon la première variante de réalisation illustrée à la figure 1, le conducteur métallique de phase 1 est situé entre la borne de connexion amont 25 et la borne de connexion aval 26.

Avantageusement, dans cette configuration qui est illustrée par la figure 1 une pièce métallique conductrice de la ligne de courant de phase L qui est située entre la borne de connexion amont 25 et la borne de connexion aval 26 est sélectionnée pour mesurer la chute de tension due au courant primaire. On évite ainsi l'ajout d'une pièce résistive. Cette solution présente l'avantage d'être compacte.

Dans ce cas, ledit au moins un conducteur métallique de phase 1 peut consister en un barreau métallique de préférence en cuivre.

Le choix d'un barreau métallique permet de faciliter le montage, d'éviter le vieillissement mécanique du fait notamment qu'il s'agit d'une pièce fixe et d'avoir une longueur suffisante pour produire un signal mesurable.

Selon la deuxième variante de réalisation, le conducteur métallique de phase 1 correspond à la borne de connexion amont 25 ou à la borne de connexion aval 26.

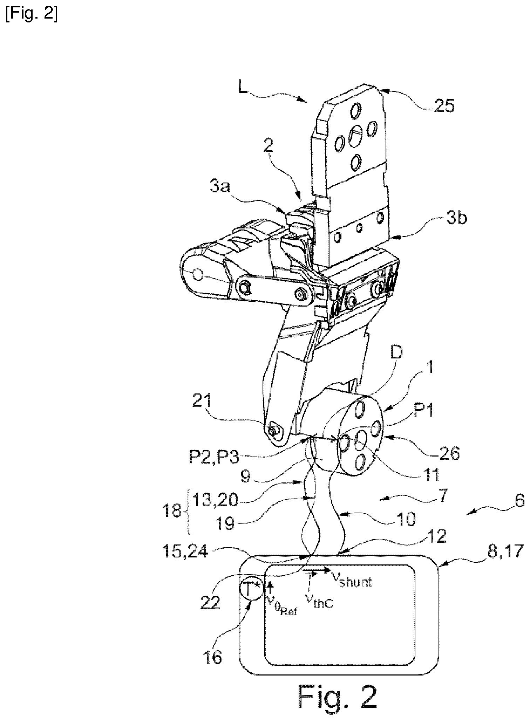

Avantageusement, dans cette configuration qui est illustrée par la figure 2 la borne de connexion amont 25 ou la borne de connexion aval 26 est sélectionnée pour mesurer la chute de tension due au courant primaire. On évite ainsi l'ajout d'une pièce résistive. Cette solution présente l'avantage d'être compacte. En outre, la borne de connexion amont 25 ou la borne de connexion aval 26 est tout comme le barreau métallique décrit précédemment une pièce fixe présentant en outre les avantages d'être facilement accessible ce qui facilite le montage et de présenter autour d'elle un espace libre de dimensions suffisantes pour recevoir l'unité de mesure 6.

De préférence, l'unité de mesure 6 comprend au moins un module électronique de mesure 27 et un module électronique de contrôle 28, le module électronique de mesure 27 étant configuré pour mesurer la valeur de la différence de tension Vshunt, la valeur de la différence de tension du câble de thermocouple 18 VthC et la valeur de la température absolue VΘRef, et le module électronique de contrôle 28 étant configuré au moins pour commander ledit module électronique de mesure 27 et pour traiter lesdites valeurs mesurées par le module électronique de mesure 27.

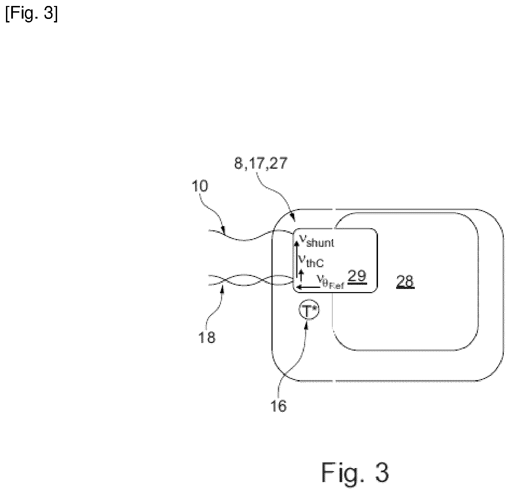

Avantageusement, grâce à cette configuration qui est illustrée par la figure 3 les différentes fonctions réalisées par l'unité de mesure 6 sont affectées au moins d'une part au module électronique de mesure 27 et d'autre part au module électronique de contrôle 28. Le module électronique de mesure 27 a pour fonction de mesurer au moins trois mesures à savoir la valeur de la différence de tension Vshunt, la valeur de la différence de tension du câble de thermocouple 18 VthC et la valeur de la température absolue VΘRef qui peuvent consister en des données analogiques. Le module électronique de contrôle 28 a pour fonction au moins de commander ledit module électronique de mesure 27 et de traiter les données de mesure provenant du module électronique de mesure 27. En outre, le module électronique de contrôle 28 implémente l'association de ces trois mesures pour déterminer la valeur du courant circulant dans le conducteur métallique de phase 1 consistant en une mesure compensée du courant primaire, et celle-ci pourra être ensuite utilisée à des fins de protection et/ou de mesure.

L'unité de mesure 6 peut comprendre un module de numérisation analogique numérique 29 relié électriquement au module électronique de mesure 27 et au module électronique de contrôle 28 pour numériser une valeur analogique de la différence de tension Vshunt, une valeur analogique de la différence de tension du câble de thermocouple 18 VthC et une valeur analogique de la température absolue VΘRef provenant du module électronique de mesure 27.

Avantageusement, grâce à cette configuration qui est illustrée par la figure 3, dans l'unité de mesure 6 le module de numérisation analogique numérique 29 a pour fonction de transformer une valeur analogique de la différence de tension Vshunt, une valeur analogique de la différence de tension du câble de thermocouple 18 VthC et une valeur analogique de la température absolue VΘRef provenant du module électronique de mesure 27 respectivement en une valeur numérique de la différence de tension Vshunt, une valeur numérique de la différence de tension du câble de thermocouple 18 VthC et une valeur numérique de la température absolue VΘRef. Ainsi cette conversion permet de faciliter le traitement des données qui sont reçues sous forme numérique par le module électronique de contrôle 28.

Préférentiellement, ledit module électronique de mesure 27, le module électronique de contrôle 28 et le module de numérisation analogique numérique 29 et le capteur de température 16 sont intégrés sur au moins une carte électronique.

Cette conception permet de miniaturiser l'unité de mesure 6.

De préférence et comme le montrent les figures, le deuxième conducteur 13 et le quatrième conducteur 20 sont confondus en un seul conducteur électrique de préférence un fil métallique et le deuxième point de connexion P2 et le troisième point de connexion P3 sont confondus en un seul point de connexion.

Avantageusement, cette configuration permet de simplifier la fabrication en limitant le nombre de conducteurs et de points de connexion sur le conducteur métallique de phase 1 et donc le cas échéant de soudure.

De préférence, le premier conducteur 10, le deuxième conducteur 13, le quatrième conducteur 20 consistent chacun en un fil métallique de préférence en cuivre.

De préférence, le quatrième conducteur 20 et le troisième conducteur 19 sont respectivement un premier fil métallique et un deuxième fil métallique en des matériaux différents, le premier fil métallique étant de préférence en cuivre et le deuxième fil métallique étant de préférence un fil d'alliage cuivre nickel dit constantan.

Avantageusement, on obtient un câble de thermocouple 18 dit de type T.

De préférence, ledit au moins un conducteur métallique de phase 1 est en un matériau métallique rigide.

Avantageusement, cette configuration permet de faciliter la fabrication et notamment le raccordement des conducteurs 10, 13, 19, 20 aux points de connexion P1, P2, P3 par des moyens de connexion électrique et thermique durable par exemple par sertissage, rivetage, brasure, soudure ou similaire.

De préférence, l'appareillage électrique de coupure comprend en outre une unité de détection de défaut 4,5 et de déclenchement sur la ligne de courant de phase L configurée pour en cas de détection d'au moins un défaut provoquer l'ouverture dudit élément de commutation 3a, 3b.

Avantageusement, l'appareillage électrique de coupure permet de réaliser une fonction de coupure et de protection contre au moins un défaut.

Le conducteur métallique de phase 1 est en un élément conducteur électrique situé sur la ligne de courant de phase L et faisant partie de la voie de courant de l'appareillage électrique de coupure. Il ne s'agit pas d'un shunt rapporté à la voie de courant. Le conducteur métallique de phase 1 comprend au moins une partie en métal ou est en métal.

L'unité de coupure 2 a pour fonction d'ouvrir et de fermer la ligne de courant de phase L à l'aide de l'élément de commutation 3a, 3b. L'unité de coupure 2 peut être électromécanique ou électronique.

L'élément de commutation 3a,3b se présente de préférence sous la forme d'au moins un ensemble de contact fixe 3a et de contact mobile 3b qui sont séparables et peuvent ainsi adopter une position de fermeture dans laquelle ils sont en contact et une position d'ouverture dans laquelle ils sont à distance. L'élément de commutation pourrait également consister en un interrupteur semiconducteur de type FET.

L'unité de détection de défaut 4,5 qui est optionnelle a pour fonction de détecter la présence d'au moins un défaut et pour fonction de provoquer l'ouverture dudit élément de commutation 3a, 3b en cas d'apparition dudit au moins un défaut.

Par exemple, l'unité de détection 4, 5 peut être de nature électromécanique et comprend un actionneur thermique 4 de type bilame et/ou un actionneur électromagnétique 5 de type bobine magnétique qui permettent respectivement la détection d'un défaut de type surcharge et/ou de type court-circuit. De manière alternative ou complémentaire, l'unité de détection 4, 5 peut être de nature électronique et permettre la détection d'un défaut de type surcharge et/ou de type court-circuit à partir de la mesure du courant circulant dans le conducteur métallique de phase 1 par l'unité de mesure 6. Dans ce cas, l'unité de détection 4, 5 et l'unité de mesure 6 sont reliés électriquement dans cet objectif.

L'unité de mesure 6 a pour fonction de fournir une valeur du courant circulant dans la ligne de courant de phase L au moins à l'aide du capteur de courant 7 associé au circuit de mesure du courant 8 et du capteur de température 16 et du câble de thermocouple 18 associés au circuit de mesure de la température 17. La valeur du courant circulant dans la ligne de courant de phase L ainsi mesurée peut être utilisée à des fins de mesures, de communication et /ou de protection.

Le segment 9 est au moins une partie du conducteur métallique de phase 1 située entre le premier point de connexion P1 et le deuxième point de connexion P2 qui sont éloignés de la distance D. Le troisième point de connexion P3 est également situé sur le conducteur métallique de phase 1 et est soit confondu avec le deuxième point de connexion P2 soit à proximité immédiate de celui-ci., il faut simplement que la température en ce troisième point de connexion P3 soit représentative de la température du conducteur métallique de phase 1 entre les points de mesure de Vshunt, à savoir le premier point de connexion P1 et le deuxième point de connexion P2. D'ailleurs dans l'hypothèse où le câble de thermocouple 18 est dissocié, il est préférable de le connecter sensiblement au milieu du segment 9 entre les points de prise de tension c'est-à-dire entre le premier point de connexion P1 et le deuxième point de connexion P2.

La distance D dépend de la résistance linéique du conducteur métallique de phase 1, du courant attendu et du moyen de mesure associé.

Le premier conducteur 10 permet de relier le premier point de connexion P1 sur le conducteur métallique de phase 1 au circuit de mesure du courant 8.

La première extrémité 11 du premier conducteur 10 est reliée de préférence par sertissage et/ou rivetage et/ou brasure soudure ou similaire au premier point de connexion P1.

La deuxième extrémité 12 du premier conducteur 10 est de préférence reliée électriquement au circuit de mesure du courant 8.

Le deuxième conducteur 13 permet de relier le deuxième point de connexion P2 sur le conducteur métallique de phase 1 au circuit de mesure du courant 8.

La première extrémité 14 du deuxième conducteur 13 est reliée de préférence par sertissage et/ou rivetage et/ou brasure soudure ou similaire au deuxième point de connexion P2.

La deuxième extrémité 15 du deuxième conducteur 13 est de préférence reliée électriquement au circuit de mesure du courant 8.

Lorsque le courant circule sur la ligne de courant de phase une différence de potentiel existe entre le premier point de connexion P1 et le deuxième point de connexion P2 et ainsi la valeur de la différence de tension Vshunt peut être déterminée par l'unité de mesure 6.

Le capteur de température 16 associé au circuit de mesure de la température 17 permet de mesurer la valeur de la température absolue VΘRef à proximité de la soudure dite froide.

Le capteur de température 16 est de préférence disposé au voisinage de la soudure froide. En effet, la soudure froide présente peu de variation de température et peut ainsi servir de valeur de référence. Cela est dû au fait que l'environnement de la soudure froide est relativement homogène en termes de température puisqu'il n'y a pas d'échauffement produit localement. Le besoin de proximité du capteur de température 16 par rapport à la soudure froide dépend du gradient de température local, il est toutefois préférable de le placer au plus près possible de la soudure froide.

Le câble de thermocouple 18 comprend le troisième conducteur 19 et le quatrième conducteur 20 ou le troisième conducteur 19 et le deuxième conducteur 13. Le troisième conducteur 19 et le quatrième conducteur 20/deuxième conducteur 13 sont reliés d'une part par la soudure dite froide et d'autre part par la soudure dite chaude.

La soudure chaude correspond au point où les deux métaux du troisième conducteur 19 et du quatrième conducteur 20/deuxième conducteur 13 sont en contact direct sous l'influence de la température à mesurer, c'est-à-dire à proximité du deuxième point de connexion P2/troisième point de connexion P3.

La soudure froide correspond au point où les deux métaux du troisième conducteur 19 et du quatrième conducteur 20/deuxième conducteur 13 sont mis en contact à travers une certaine impédance afin de mesurer la chute de tension.

Le câble de thermocouple 18 associé au circuit de mesure de la température 17 permet de mesurer la valeur de la différence de tension du câble de thermocouple 18 VthC.

A partir de la température absolue VΘRef et de la différence de tension du câble de thermocouple 18 VthC, il est possible de déduire la valeur de la température dans le conducteur métallique de phase 1. La différence de tension mesurée aux bornes du thermocouple est l'image de la différence de température entre la soudure chaude et la soudure froide. Il faut donc ajouter la température absolue mesurée à la soudure froide afin d'obtenir la température à la soudure chaude.

Le troisième conducteur 19 permet de relier le deuxième point de connexion P2/troisième point de connexion P3 sur le conducteur métallique de phase 1 au circuit de mesure de la température 17.

La première extrémité 21 du troisième conducteur 19 est reliée de préférence par sertissage et/ou rivetage et/ou brasure soudure ou similaire au deuxième point de connexion P2/troisième point de connexion P3.

La deuxième extrémité 22 du troisième conducteur 19 est de préférence reliée électriquement au circuit de mesure de la température 17.

Le quatrième conducteur 20 permet de relier le deuxième point de connexion P2/troisième point de connexion P3 sur le conducteur métallique de phase 1 au circuit de mesure de la température 17.

La première extrémité 23 du quatrième conducteur 20 est reliée de préférence par sertissage et/ou rivetage et/ou brasure soudure ou similaire au deuxième point de connexion P2/troisième point de connexion P3.

La deuxième extrémité 24 du quatrième conducteur 20 est de préférence reliée électriquement au circuit de mesure de la température 17.

La borne de connexion amont 25 et borne de connexion aval 26 peuvent être une borne à cage à vis (figure 1) ou à serrage automatique ou une plage d'accueil de bornes à visser (figure 2).

Le module électronique de mesure 27 fait partie de l'unité de mesure 6 et permet de mesurer la valeur de la différence de tension Vshunt, la valeur de la différence de tension du câble de thermocouple 18 VthC et la valeur de la température absolue VΘRef. Il correspond au circuit de mesure du courant 8 et au circuit de mesure de la température 17.

Le module électronique de contrôle 28 fait partie de l'unité de mesure 6 et permet de commander ledit module électronique de mesure 27 et de traiter lesdites valeurs mesurées par le module électronique de mesure 27 notamment pour en déduire la valeur du courant circulant dans le conducteur métallique de phase 1.

Le module de numérisation analogique numérique 29 fait partie de l'unité de mesure 6 pour numériser une valeur analogique de la différence de tension Vshunt, une valeur analogique de la différence de tension du câble de thermocouple 18 VthC et une valeur analogique de la température absolue VΘRef provenant du module électronique de mesure 27.

Le module électronique de contrôle 28 permet de commander le module de numérisation analogique numérique 29 et de traiter lesdites valeurs mesurées et converties en données numériques par le module de numérisation analogique numérique 29 notamment pour en déduire la valeur du courant circulant dans le conducteur métallique de phase 1.

L'unité de mesure 6 est de préférence entourée par un boîtier contenant le capteur de température 16, le module électronique de mesure 27, le module électronique de contrôle 28 et le module de numérisation analogique numérique 29.

L'appareillage électrique de coupure peut être un contacteur, un interrupteur, un interrupteur commandé.

L'appareillage électrique de coupure peut en outre réaliser une fonction de protection et dans ce cas peut être un disjoncteur, un interrupteur différentiel, un disjoncteur différentiel ou similaire.

La figure 1 illustre partiellement l'appareillage électrique de coupure et de protection selon la première variante de réalisation selon l'invention qui est du type disjoncteur. Dans cet exemple, le conducteur métallique de phase 1 est situé entre la borne de connexion amont 25 et la borne de connexion aval 26. Le conducteur métallique de phase 1 se présente sous la forme du barreau métallique en cuivre et rigide de la ligne de courant de phase L. Le segment 9 est une partie du barreau métallique.

La ligne de courant de phase L comprend en amont la borne de connexion amont 25 reliée électriquement à l'actionneur électromagnétique de type bobine magnétique pour la détection de défaut de type court-circuit par l'intermédiaire du conducteur métallique de phase 1 se présentant sous la forme du barreau métallique de préférence en cuivre et rigide. Le segment 9 est une partie du barreau métallique. Le premier point de connexion P1 est à proximité de la borne de connexion amont 25, tandis que le deuxième point de connexion P2 est à proximité de l'actionneur électromagnétique 5. Dans cet exemple, le deuxième conducteur 13 et le quatrième conducteur 20 sont confondus en un seul conducteur électrique sous la forme d'un fil métallique et le deuxième point de connexion P2 et le troisième point de connexion P3 sont confondus en un seul point de connexion. L'unité de coupure 2 comprend un contact fixe 3a et un contact mobile 3b. L'actionneur électromagnétique 5 est relié électriquement au contact fixe 3a. Le contact mobile 3b est relié à l'actionneur thermique 4 de type bilame pour la détection de défaut de type surcharge par l'intermédiaire d'un premier conducteur flexible 30 de type tresse. L'actionneur thermique 4 est relié électriquement à la borne de connexion aval 26 par un deuxième conducteur flexible 31 de type tresse.

La figure 2 illustre partiellement un appareillage électrique de coupure selon la deuxième variante de réalisation selon l'invention. Dans cet exemple, le conducteur métallique de phase 1 correspond à la borne de connexion aval 26. Par conséquent, le segment 9 est une partie de la borne de connexion aval 26. Le premier point de connexion P1, le deuxième point de connexion P2/troisième point de connexion P3 sont tous sur la borne de connexion aval 26. Le deuxième conducteur 13 et le quatrième conducteur 20 sont confondus en un seul conducteur électrique sous la forme d'un fil métallique et le deuxième point de connexion P2 et le troisième point de connexion P3 sont confondus en un seul point de connexion.

La figure 3 illustre l'unité de mesure 6 selon une possibilité de l'invention qui comprend le capteur de température 16, le module électronique de mesure 27, le module électronique de contrôle 28 et le module de numérisation analogique numérique 29. Le module électronique de mesure 27 est relié au premier conducteur 10 et au câble de thermocouple 18.

Bien entendu, l'invention n'est pas limitée aux modes de réalisation décrits et représentés aux dessins annexés. Des modifications restent possibles, notamment du point de vue de la constitution des divers éléments, sans sortir pour autant du domaine de protection de l'invention.

## Revendications

1. Appareillage électrique de coupure comportant au moins :
- une ligne de courant de phase (L) comprenant au moins un conducteur métallique de phase (1),
- une unité de coupure (2) comprenant au moins un élément de commutation (3a,3b) sur la ligne de courant de phase (L),
- une unité de mesure (6) comprenant au moins un capteur de courant (7) et un circuit de mesure du courant (8),
appareillage électrique de coupure **caractérisé en ce que** :
- le capteur de courant (7) intègre un segment (9) dudit conducteur métallique de phase (1) situé entre un premier point de connexion (P1) et un deuxième point de connexion (P2) distants l'un de l'autre d'une distance (D) prédéfinie et **en ce que** l'unité de mesure (6) comprend un premier conducteur (10) raccordé par une première extrémité (11) au premier point de connexion (P1) et par une deuxième extrémité (12) au circuit de mesure du courant (8) et un deuxième conducteur (13) raccordé par une première extrémité (14) au deuxième point de connexion (P2) et par une deuxième extrémité (15) au circuit de mesure du courant (8) et
- l'unité de mesure (6) comprend en outre un capteur de température (16) et un circuit de mesure de la température (17) et au moins un câble de thermocouple (18) comprenant un troisième conducteur (19) et un quatrième conducteur (20) reliés l'un l'autre au niveau d'une soudure dite froide et une soudure dite chaude, le troisième conducteur (19) comprenant une première extrémité (21) et une deuxième extrémité (22), et le quatrième conducteur (20) comprenant une première extrémité (23) et une deuxième extrémité (24), lesquels sont raccordés respectivement par leur première extrémité (21, 23) à un troisième point de connexion (P3) confondu avec le ou à proximité du deuxième point de connexion (P2) et étant au voisinage de la soudure chaude et à leur deuxième extrémité (22, 24), étant voisine de la soudure dite froide, au circuit de mesure de la température (17),
- ladite unité de mesure (6) est configurée au moins pour mesurer la valeur de la différence de tension (Vshunt) entre le premier conducteur (10) et le deuxième conducteur (13), la valeur de la différence de tension du câble de thermocouple (18) (VthC) et la valeur de la température absolue (VΘRef) à proximité de la soudure dite froide à l'aide du capteur de température (16), de sorte à déterminer la valeur du courant circulant dans le conducteur métallique de phase (1).

2. Appareillage électrique de coupure selon la revendication 1, **caractérisé en ce que** la ligne de courant de phase (L) comprend une borne de connexion amont (25) et une borne de connexion aval (26), ladite unité de coupure (2) étant située entre la borne de connexion amont (25) et la borne de connexion aval (26).

3. Appareillage électrique de coupure selon la revendication 2, **caractérisé en ce que** le conducteur métallique de phase (1) est situé entre la borne de connexion amont (25) et la borne de connexion aval (26).

4. Appareillage électrique de coupure selon les revendications 2 et 3, **caractérisé en ce que** ledit au moins un conducteur métallique de phase (1) consiste en un barreau métallique de préférence en cuivre.

5. Appareillage électrique de coupure selon la revendication 2, **caractérisé en ce que** le conducteur métallique de phase (1) correspond à la borne de connexion amont (25) ou à la borne de connexion aval (26).

6. Appareillage électrique de coupure selon l'une quelconque des revendications 1 à 5, **caractérisé en ce que** l'unité de mesure (6) comprend au moins un module électronique de mesure (27) et un module électronique de contrôle (28), le module électronique de mesure (27) étant configuré pour mesurer la valeur de la différence de tension (Vshunt), la valeur de la différence de tension du câble de thermocouple (18) (VthC) et la valeur de la température absolue (VΘRef), et le module électronique de contrôle (28) étant configuré au moins pour commander ledit module électronique de mesure (27) et pour traiter lesdites valeurs mesurées par le module électronique de mesure (27).

7. Appareillage électrique de coupure selon la revendication 6, **caractérisé en ce que** l'unité de mesure (6) comprend un module de numérisation analogique numérique (29) relié électriquement au module électronique de mesure (27) et au module électronique de contrôle (28) pour numériser une valeur analogique de la différence de tension (Vshunt), une valeur analogique de la différence de tension du câble de thermocouple (18) (VthC) et une valeur analogique de la température absolue (VΘRef) provenant du module électronique de mesure (27).

8. Appareillage électrique de coupure selon les revendications 6 et 7, **caractérisé en ce que** ledit module électronique de mesure (27), le module électronique de contrôle (28) et le module de numérisation analogique numérique (29) et le capteur de température (16) sont intégrés sur au moins une carte électronique.

9. Appareillage électrique de coupure selon l'une quelconque des revendications 1 à 8, **caractérisé en ce que** le deuxième conducteur (13) et le quatrième conducteur (20) sont confondus en un seul conducteur électrique de préférence un fil métallique et **en ce que** le deuxième point de connexion (P2) et le troisième point de connexion (P3) sont confondus en un seul point de connexion.

10. Appareillage électrique de coupure selon l'une quelconque des revendications 1 à 9, **caractérisé en ce que** le premier conducteur (11), le deuxième conducteur (13), le quatrième conducteur (20) consistent chacun en un fil métallique de préférence en cuivre.

11. Appareillage électrique de coupure selon l'une quelconque des revendications 1 à 10, **caractérisé en ce que** le quatrième conducteur (20) et le troisième conducteur (19) sont respectivement un premier fil métallique et un deuxième fil métallique en des matériaux différents, le premier fil métallique étant de préférence en cuivre et le deuxième fil métallique étant de préférence un fil d'alliage cuivre nickel dit constantan.

12. Appareillage électrique de coupure selon l'une quelconque des revendications 1 à 11, **caractérisé en ce que** ledit au moins un conducteur métallique de phase (1) est en un matériau métallique rigide.

13. Appareillage électrique de coupure selon l'une quelconque des revendications 1 à 12, **caractérisé en ce qu'**il comprend en outre une unité de détection de défaut (4,5) et de déclenchement sur la ligne de courant de phase (L) configurée pour en cas de détection d'au moins un défaut provoquer l'ouverture dudit élément de commutation (3a, 3b).

## Patentansprüche

1. Elektrisches Schaltgerät, aufweisend mindestens:
- eine Phasenstromleitung (L), die mindestens einen metallischen Phasenleiter (1) umfasst;
- eine Schalteinheit (2), die mindestens ein Schaltelement (3a, 3b) an der Phasenstromleitung (L) umfasst,
- eine Messeinheit (6), die mindestens einen Stromsensor (7) und einen Strommesskreis (8) umfasst,
wobei das elektrische Schaltgerät **dadurch gekennzeichnet ist, dass**:
- der Stromsensor (7) ein Segment (9) des metallischen Phasenleiters (1) beinhaltet, das zwischen einem ersten Anschlusspunkt (P1) und einem zweiten Anschlusspunkt (P2) gelegen ist, die voneinander um einen vordefinierten Abstand (D) beabstandet sind, und dass die Messeinheit (6) einen ersten Leiter (10), der über ein erstes Ende (11) mit dem ersten Anschlusspunkt (P1) und über ein zweites Ende (12) mit dem Strommesskreis (8) verbunden ist, und einen zweiten Leiter (13), der über ein erstes Ende (14) mit dem zweiten Anschlusspunkt (P2) und über ein zweites Ende (15) mit dem Strommesskreis (8) verbunden ist, umfasst, und
- die Messeinheit (6) ferner einen Temperatursensor (16) und einen Temperaturmesskreis (17) umfasst und mindestens ein Thermoelementkabel (18), das einen dritten Leiter (19) und einen vierten Leiter (20) umfasst, die mit einer sogenannten kalten Lötstelle und mit einer sogenannten heißen Lötstelle verbunden sind, wobei der dritte Leiter (19) ein erstes Ende (21) und ein zweites Ende (22) umfasst und wobei der vierte Leiter (20) ein erstes Ende (23) und ein zweites Ende (24) umfasst, die jeweils über ihr erstes Ende (21, 23) mit einem dritten Anschlusspunkt (P3) verbunden sind, der mit dem zweiten Anschlusspunkt (P2) zusammenfällt oder in seiner Nähe liegt und zu der heißen Lötstelle benachbart ist, und über ihr zweites Ende (22, 24), das zu der sogenannten kalten Lötstelle benachbart ist, mit dem Temperaturmesskreis (17) verbunden sind,
- die Messeinheit (6) mindestens dazu ausgelegt ist, den Wert der Spannungsdifferenz (Vshunt) zwischen dem ersten Leiter (10) und dem zweiten Leiter (13), den Wert der Spannungsdifferenz des Thermoelementkabels (18) (VthC) und den Wert der absoluten Temperatur (VΘRef) in der Nähe der sogenannten kalten Lötstelle mithilfe des Temperatursensors (16) zu messen, so dass der Wert des in dem metallischen Phasenleiter (1) fließenden Stroms bestimmt wird.

2. Elektrisches Schaltgerät nach Anspruch 1, **dadurch gekennzeichnet, dass** die Phasenstromleitung (L) eine vorgelagerte Anschlussklemme (25) und eine nachgelagerte Anschlussklemme (26) umfasst, wobei die Schalteinheit (2) zwischen der vorgelagerten Anschlussklemme (25) und der nachgelagerten Anschlussklemme (26) gelegen ist.

3. Elektrisches Schaltgerät nach Anspruch 2, **dadurch gekennzeichnet, dass** der metallische Phasenleiter (1) zwischen der vorgelagerten Anschlussklemme (25) und der nachgelagerten Anschlussklemme (26) gelegen ist.

4. Elektrisches Schaltgerät nach den Ansprüchen 2 und 3, **dadurch gekennzeichnet, dass** der mindestens eine metallische Phasenleiter (1) aus einem metallischen Stab, vorzugsweise aus Kupfer, besteht.

5. Elektrisches Schaltgerät nach Anspruch 2, **dadurch gekennzeichnet, dass** der metallische Phasenleiter (1) der vorgelagerten Anschlussklemme (25) oder der nachgelagerten Anschlussklemme (26) entspricht.

6. Elektrisches Schaltgerät nach einem der Ansprüche 1 bis 5, **dadurch gekennzeichnet, dass** die Messeinheit (6) mindestens ein elektronisches Messmodul (27) und ein elektronisches Steuermodul (28) umfasst, wobei das elektronische Messmodul (27) dazu ausgelegt ist, den Wert der Spannungsdifferenz (Vshunt), den Wert der Spannungsdifferenz des Thermoelementkabels (18) (VthC) und den Wert der absoluten Temperatur (VΘRef) zu messen, und wobei das elektronische Steuermodul (28) mindestens dazu ausgelegt ist, das elektronische Messmodul (27) zu steuern und die von dem elektronischen Messmodul (27) gemessenen Werte zu verarbeiten.

7. Elektrisches Schaltgerät nach Anspruch 6, **dadurch gekennzeichnet, dass** die Messeinheit (6) ein Analog/Digital-Digitalisierungsmodul (29) umfasst, das elektrisch mit dem elektronischen Messmodul (27) und dem elektronischen Steuermodul (28) verbunden ist, um einen analogen Wert der Spannungsdifferenz (Vshunt), einen analogen Wert der Spannungsdifferenz des Thermoelementkabels (18) (VthC) und einen analogen Wert der absoluten Temperatur (VΘRef), die von dem Messelektronikmodul (27) stammen, zu digitalisieren.

8. Elektrisches Schaltgerät nach den Ansprüchen 6 und 7, **dadurch gekennzeichnet, dass** das elektronische Messmodul (27), das elektronische Steuermodul (28) und das Analog/Digital-Digitalisierungsmodul (29) und der Temperatursensor (16) auf mindestens einer elektronischen Karte integriert sind.

9. Elektrisches Schaltgerät nach einem der Ansprüche 1 bis 8, **dadurch gekennzeichnet, dass** der zweite Leiter (13) und der vierte Leiter (20) zu einem einzigen elektrischen Leiter, vorzugsweise einem Metalldraht, zusammengeführt sind, und dass der zweite Anschlusspunkt (P2) und der dritte Anschlusspunkt (P3) zu einem einzigen Anschlusspunkt zusammengeführt sind.

10. Elektrisches Schaltgerät nach einem der Ansprüche 1 bis 9, **dadurch gekennzeichnet, dass** der erste Leiter (11), der zweite Leiter (13), der vierte Leiter (20) jeweils aus einem Metalldraht, vorzugsweise aus Kupfer, bestehen.

11. Elektrisches Schaltgerät nach einem der Ansprüche 1 bis 10, **dadurch gekennzeichnet, dass** der vierte Leiter (20) und der dritte Leiter (19) ein erster Metalldraht bzw. ein zweiter Metalldraht aus verschiedenen Materialien sind, wobei der erste Metalldraht vorzugsweise aus Kupfer ist und der zweite Metalldraht vorzugsweise ein Draht aus einer als Konstantan bezeichneten Kupfer-Nickel-Legierung ist.

12. Elektrisches Schaltgerät nach einem der Ansprüche 1 bis 11, **dadurch gekennzeichnet, dass** der mindestens eine metallische Phasenleiter (1) aus einem starren metallischen Material ist.

13. Elektrisches Schaltgerät nach einem der Ansprüche 1 bis 12, **dadurch gekennzeichnet, dass** es ferner eine Einheit (4,5) zur Fehlererkennung und zum Auslösen an der Phasenstromleitung (L) aufweist, die dazu ausgelegt ist, im Fall der Erkennung mindestens eines Fehlers das Öffnen des Schaltelements (3a, 3b) zu bewirken.

## Claims

1. Electrical switchgear comprising at least:
- a phase current line (L) comprising at least one metal phase conductor (1),
- a switching unit (2) comprising at least one switching element (3a, 3b) on the phase current line (L),
- a measuring unit (6) comprising at least one current sensor (7) and a current measuring circuit (8),
said electrical switchgear being **characterized in that**:
- the current sensor (7) integrates a segment (9) of said metal phase conductor (1) located between a first connection point (P1) and a second connection point (P2) which are spaced apart from one another by a predetermined distance (D), and **in that** the measuring unit (6) comprises a first conductor (10) connected by a first end (11) to the first connection point (P1) and by a second end (12) to the current measuring circuit (8) and a second conductor (13) connected by a first end (14) to the second connection point (P2) and by a second end (15) to the current measuring circuit (8) and
- the measuring unit (6) further comprises a temperature sensor (16) and a temperature measuring circuit (17) and at least one thermocouple cable (18) comprising a third conductor (19) and a fourth conductor (20) which are connected to one another at a so-called cold junction and a so-called hot junction, the third conductor (19) comprising a first end (21) and a second end (22), and the fourth conductor (20) comprising a first end (23) and a second end (24), which conductors are respectively connected by their first end (21, 23) to a third connection point (P3) combined with or near the second connection point (P2) and being in the vicinity of the hot junction and at their second end (22, 24), being close to the so-called cold junction, to the temperature measuring circuit (17),
- said measuring unit (6) is configured at least to measure the value of the voltage difference (Vshunt) between the first conductor (10) and the second conductor (13), the value of the voltage difference of the thermocouple cable (18) (VthC) and the value of the absolute temperature (VΘRef) near the so-called cold junction by means of the temperature sensor (16), so as to determine the value of the current flowing through the metal phase conductor (1).

2. Electrical switchgear according to Claim 1, **characterized in that** the phase current line (L) comprises an upstream connection terminal (25) and a downstream connection terminal (26), the switching unit (2) being located between the upstream connection terminal (25) and the downstream connection terminal (26).

3. Electrical switchgear according to Claim 2, **characterized in that** the metal phase conductor (1) is located between the upstream connection terminal (25) and the downstream connection terminal (26).

4. Electrical switchgear according to Claims 2 and 3, **characterized in that** said at least one metal phase conductor (1) consists of a metal bar, preferably made of copper.

5. Electrical switchgear according to Claim 2, **characterized in that** the metal phase conductor (1) corresponds to the upstream connection terminal (25) or to the downstream connection terminal (26).

6. Electrical switchgear according to any one of Claims 1 to 5, **characterized in that** the measuring unit (6) comprises at least one electronic measuring module (27) and an electronic control module (28), the electronic measuring module (27) being configured to measure the value of the voltage difference (Vshunt), the value of the voltage difference of the thermocouple cable (18) (VthC) and the value of the absolute temperature (VΘRef), and the electronic control module (28) being configured at least to control said electronic measuring module (27) and to process said values measured by the electronic measuring module (27).

7. Electrical switchgear according to Claim 6, **characterized in that** the measuring unit (6) comprises an analogue-to-digital digitization module (29) electrically connected to the electronic measuring module (27) and to the electronic control module (28) in order to digitize an analogue value of the voltage difference (Vshunt), an analogue value of the voltage difference of the thermocouple cable (18) (VthC) and an analogue value of the absolute temperature (VΘRef) from the electronic measuring module (27).

8. Electrical switchgear according to Claims 6 and 7, **characterized in that** said electronic measuring module (27), the electronic control module (28) and the analogue-to-digital digitization module (29) and the temperature sensor (16) are integrated on at least one circuit board.

9. Electrical switchgear according to any one of Claims 1 to 8, **characterized in that** the second conductor (13) and the fourth conductor (20) are combined into a single electrical conductor, preferably a metal wire, and **in that** the second connection point (P2) and the third connection point (P3) are combined into a single connection point.

10. Electrical switchgear according to any one of Claims 1 to 9, **characterized in that** the first conductor (11), the second conductor (13) and the fourth conductor (20) each consist of a metal wire, preferably made of copper.

11. Electrical switchgear according to any one of Claims 1 to 10, **characterized in that** the fourth conductor (20) and the third conductor (19) are a first metal wire and a second metal wire, respectively, made of different materials, the first metal wire preferably being made of copper and the second metal wire preferably being a wire of copper-nickel alloy called constantan.

12. Electrical switchgear according to any one of Claims 1 to 11, **characterized in that** said at least one metal phase conductor (1) is made of a rigid metal material.

13. Electrical switchgear according to any one of Claims 1 to 12, **characterized in that** it further comprises a fault detection and tripping unit (4, 5) on the phase current line (L), configured to cause said switching element (3a, 3b) to open in the event of at least one fault being detected.
